# EUROPÄISCHE PATENTSCHRIFT

(11) **EP 0 898 802 B1**
(45) Veröffentlichungstag und Bekanntmachung des Hinweises auf die Patenterteilung: **19.09.2001**
(21) Anmeldenummer: 97904440.1
(22) Anmeldetag: 13.02.1997
(51) Int. Cl.: H02H 9/04, H01M 2/34, H01T 1/14

(54) **VORRICHTUNG ZUM SCHUTZ EINER ELEKTRONISCHEN SCHALTUNG**
PROTECTIVE DEVICE FOR AN ELECTRONIC CIRCUIT
DISPOSITIF POUR PROTEGER UN CIRCUIT ELECTRONIQUE

(30) Priorität: 15.05.1996 DE 19619631; 14.11.1996 DE 19647035
(43) Veröffentlichungstag der Anmeldung: 03.03.1999
(73) Patentinhaber: FRIWO Gerätebau GmbH, 48346 Ostbevern (DE); VARTA Gerätebatterie GmbH, 30419 Hannover (DE); SIEMENS AKTIENGESELLSCHAFT, 81541 München (DE)
(72) Erfinder: BOTHE, Michael, D-49546 Ladbergen (DE); WEGENER, Armin, D-48291 Telgte (DE); HEYDECKE, Jürgen, D-58553 Halver (DE); KNOP, Ingmar, D-73433 Aalen (DE); GOEBEL, Klaus, D-80804 München (DE); SKWIRBLIES, Klaus-Dieter, D-85661 Forstinning (DE); PETERS, Rainer, D-82008 Unterhachung (DE)
(74) Vertreter: Ackmann, Günther, Dr.
(86) Internationale Anmeldenummer: EP9700689
(87) Internationale Veröffentlichungsnummer: WO9743812

(56) Entgegenhaltungen:
- EP-A- 0 130 403
- EP-A- 0 270 044
- US-A- 5 311 164

## Beschreibung

Die Erfindung betrifft eine Vorrichtung zum Schutz einer elektronischen Schaltung und/oder eines nachgeschalteten elektrischen Verbrauchers gegen Zuführung unzulässig hoher elektrischer Energie.

Elektrische Geräte wie Handtelefone und dergleichen werden zur Stromversorgung bzw. Batterieaufladung über eine Steckbuchse mit einem Netzgerät oder Ladegerät verbunden. Zum Schutz gegen zu hohe Ladespannung oder Überlastung wird die Schaltung meist mit einem Regler ausgerüstet, der mit einem Transistor, einer Zener-Diode o.dgl. versehen und als Längsregler oder Shunt-Regler geschaltet ist. Bei der Stromversorgung bzw. Batterieaufladung solcher Geräte besteht die Gefahr, daß durch Verwendung ungeeigneter Netzgeräte bzw. Ladegeräte, die auch mit Hilfe eines entsprechenden Adapters angeschlossen sein könnten, eine unzulässig hohe Spannung auf die interne Schutzschaltung einwirkt, durch welche die elektronische Schaltung zerstört wird.

Aus US 5 311 164A ist eine Schaltung bekannt, bei der in der Stromzuleitung zum Verbraucher eine Schmelzsicherung in Reihe und zusätzlich zwischen den beiden Strompfaden eine MELF-Vorrichtung parallel zum Verbraucher geschaltet ist. Die MELF-Vorrichtung dient der Absorption von Stromspitzen. Um eine Überhitzung und Zerstörung durch Feuer zu vermeiden, ist das MELF-Element auf einer Grundplatte durch Schmelzlot mit den Strompfaden verbunden und von einer Druckfeder beaufschlagt, die bei dem Aufschmelzen des Lots das MELF-Element von den beiden Strompfaden abhebt. Damit ist aber nur das MELF-Element, nicht aber der Verbraucher von den beiden Strompfaden bzw. -zuleitungen getrennt. Vielmehr erfolgt die Abtrennung des Verbrauchers erst später, wenn die in Serie geschaltete Schmelzsicherung schmilzt und die zugehörige Stromleitung unterbricht. Diese vorbekannte Schutzschaltung umfaßt somit zwei Schmelzsicherungen, von der die mit dem Federelement kombinierte Schmelzsicherung nur dem Schutz des parallel zum Verbraucher geschalteten MELF-Elements dient, während die Abtrennung des Verbrauchers von der Stromzuleitung durch eine zweite, in Reihe zum Verbraucher geschalteten Schmelzsicherung erfolgt.

Ausgehend von diesem Stand der Technik liegt der Erfindung die Aufgabe zugrunde, eine dem Oberbegriff des Anspruchs 1 entsprechende Vorrichtung derart auszubilden, daß beim Auslöten der Lötflächen des Bauelements gleichzeitig sowohl das die Spannung begrenzende Bauelement als auch der Verbraucher von der Stromversorgung abgeschaltet ist.

Wird fälschlicherweise an das Gerät eine Stromquelle bzw. ein Ladegerät mit einer unzulässig hohen Energiezufuhr angelegt, wird infolge der durch die Energiezufuhr bedingten Erwärmung des Bauelements der Stromkreis unterbrochen und sowohl das Bauelement als auch der Verbraucher von der Stromversorgung abgeschaltet.

Das für den Schutz des Verbrauchers und des Spannungsbegrenzers benötigte Bauteil ist von besonders einfachem Aufbau. Auf einer Leiterplatte ist für zwei Strompfade je eine Leiterbahn vorgesehen, die durch Lötflächenpärchen unterbrochen sind, von denen jeweils die eine Lötfläche an die Stromquelle und die andere an den Verbraucher angeschlossen ist, wobei die Anschlußteile des Bauelements mit den Lötflächenpärchen verlötet sind. Dabei wird das Bauelement durch eine Feder unter mechanischer Vorspannung gehalten und im Falle eines Auslötens sicher von den Lötflächenpärchen getrennt. Für eine einfache Verbindung sind die Leiterbahnen für die Anschlüsse der Strompfade mit Lötflächen versehen und die Lötflächen für die Diode liegen nebeneinander unter den Anschlußteilen der Diode. Zum Löten des Bauelements wird vorzugsweise ein Lot mit definiertem Schmelzpunkt in Abhängigkeit von der festgelegten zulässigen Aufheiztemperatur gewählt. Als Feder kann eine Blattfeder vorgesehen sein, die mit wenigstens einer durch einen Schlitz in die Leiterplatte ragenden Schulter gegen das Bauelement drückt. Eine Blattfeder ist leicht an der Leiterplatte befestigbar, indem sie an einem Ende in einem Randausschnitt der Leitplatte liegt und mit seitlichen Schenkeln auf der Leiterplatte aufliegt, während am anderen Ende der Blattfeder eine in eine Öffnung der Leiterplatte eingreifende Hakensperre vorgesehen ist. Das Bauelement kann beispielsweise eine Suppressor-Diode sein, die den definierten Spannungswert festlegt. Verbraucher kann ein Akkumulator sein, der zusammen mit der Schutzvorrichtung in einem Gehäuse untergebracht ist. Besonders geeignet ist die Schutzvorrichtung für einen Akkumulator, der aus wenigstens einer Li-Ion-Zelle besteht.

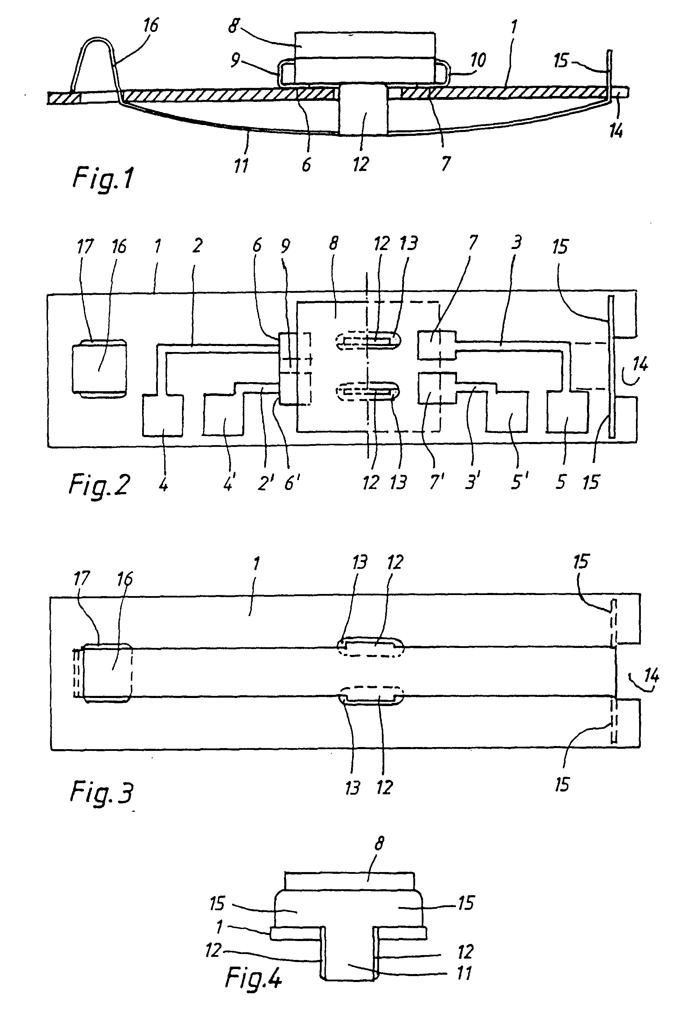

Ein Ausführungsbeispiel der Erfindung ist in der Zeichnung dargestellt; es zeigt
- Fig. 1: eine Schutzvorrichtung in einem Längsschnitt in einer starken Vergrößerung,
- Fig. 2: die Oberfläche des Gegenstandes der Fig. 1 ,
- Fig. 3: die Unterseite des Gegenstandes der Fig. 1 und
- Fig. 4: den Gegenstand der Fig.1 in einer Ansicht von einer Stirnseite.

Die Teile der Schutzvorrichtung sind auf einer Leiterplatte 1 angeordnet, die aus einem geeigneten Kunststoff, z.B. Epoxidharz besteht. Auf der Leiterplatte 1 sind vier Leiterbahnen 2,2',3,3' angeordnet, die mit Lötflächen 4,4',5,5' versehen sind. Die Lötfläche 4 dient dem Anschluß des zum Netzgerät oder Ladegerät führenden negativen Strompfads und die Lötfläche 4' der Verbindung mit dem negativen Strompfad der elektronischen Geräteschaltung. Entsprechend sind die Lötflächen 5,5' mit dem positiven Strompfad des Netzgerätes oder des Ladegerätes bzw. der elektronischen Geräteschaltung zu verbinden. An den anderen Enden der Leiterbahnen 2,2'3,3' sind Lötflächen 6,6',7,7' vorgesehen, die paarweise mit einem die Strompfade unterbrechenden Abstand nebeneinander unter den Anschlußteilen 9,10 eines Bauelements, z.B.einer Diode 8, die ein Suppressor-Diode sein kann, angeordnet sind. Die Anschlußteile 9,10 der Diode 8 sind mit diesen Lötflächen 6,6',7,7' verlötet, so daß die Leiterbahnen 2,2' bzw. 3,3' über die Anschlußteile 9,10 stromleitend miteinander verbunden sind. Zum Verlöten der Diode 1 wird ein Weichlot in Abhängigkeit von der festgelegten zulässigen Aufheiztemperatur gewählt.

Wesentlicher Bestandteil der Erfindung ist eine unter der Leiterplatte 1 angeordnete Feder in Form einer Blattfeder 11, die im mittleren Bereich zwei seitliche Schultern 12 hat, welche durch zwei Schlitze 13 durch die Leiterplatte 1 ragen und mit einer Federkraft gegen die Unterfläche der Diode 8 drücken. An einem Ende -ist die Blattfeder 11 nach oben abgebogen und führt durch einen Randausschnitt an der Stirnseite der Leiterplatte 1 und ist mit zwei seitlichen Schultern 15 versehen, die auf der Leiterplatte 1 aufliegen. Am andern Ende ist die Blattfeder 11 mit einer Hakensperre 16 versehen die durch eine in der Leiterplatte 1 angeordnete Öffnung 17 ragt und sich auf der Oberfläche der Leiterplatte 1 abstützt. Hierdurch ist die Blattfeder 11 an ihren beiden Enden an der Leiterplatte 1 fixiert und übt eine gegen die Leiterplatte 1 gerichtete Federkraft aus.

Bei Normalbetrieb fließt über die Diode 8 lediglich ein vernachlässigbarer Ruhestrom. Kommt es aber infolge eines Fehlanschlusses zu unzulässig hohen Spannungen und erweicht oder schmilzt das Lot an den Lotflächen 6,6',7,7', drückt die Blattfeder 11 die Diode 8 nach oben von den Lötflächen 6,6',7,7' weg, so daß die beiden Strompfade unterbrochen sind und die angestrebte Schutzwirkung stattfindet.

### Bezugszeichenliste

- 1: Leiterplatte
- 2: Leiterbahn
- 2': Leiterbahn
- 3: Leiterbahn
- 3': Leiterbahn
- 4: Lötfläche
- 4': Lötfläche
- 5: Lötfläche
- 5': Lötfläche
- 6: Lötfläche
- 6': Lötfläche
- 7: Lötfläche
- 7': Lötfläche
- 8: Diode (Bauelement)
- 9: Anschlußteil
- 10: Anschlußteil
- 11: Blattfeder
- 12: Schulter
- 13: Schlitze
- 14: Randausschnitt
- 15: Schulter
- 16: Hakensperre
- 17: Öffnung

## Patentansprüche

1. Vorrichtung zum Schutz einer elektronischen Schaltung und/oder eines nachgeschalteten Verbrauchers gegen Zuführung unzulässig hoher elektrischer Energie, bestehend aus einem die Spannung begrenzenden Bauelement, dessen Anschlußteile über Lötflächen (5,5',6,6',7,7') mit den beiden Strompfaden des Verbrauchers verbunden sind und das durch eine Feder (11) unter mechanischer Vorspannung gehalten und im Falle des Auslötens von der Lötfläche abgehoben und von den Strompfaden getrennt wird, **dadurch gekennzeichnet, daß** auf einer Leitplatte (1) für zwei Strompfade je eine Leiterbahn (2,2' bzw. 3,3') vorgesehen ist, die durch Lötflächenpärchen (6,6' bzw. 7,7') unterbrochen sind, von denen jeweils die eine Lötfläche an die Stromquelle und die andere an den Verbraucher angeschlossen ist und daß die Anschlußteile (9,10) des Bauelements (8) mit den Lötflächenpärchen (6,6' bzw. 7,7') verlötet sind.

2. Vorrichtung nach Anspruche 1, **dadurch gekennzeichnet, daß** die Leiterbahnen (2,2' bzw. 3,3') mit Lötflächen (4,4';5,5') für die Anschlüsse der Strompfade versehen sind und die Lötflächen (6,6';7,7') für das Bauelement (8) nebeneinander unter den Anschlußteilen (9,10) des Bauelementes (8) liegen.

3. Vorrichtung nach einem der Ansprüche 1 bis 6, **dadurch gekennzeichnet, daß** zum Löten des Bauelementes (8) ein Lot mit definiertem Schmelzpunkt in Abhängigkeit von der festgelegten zulässigen Aufheiztemperatur gewählt wird.

4. Vorrichtung nach einem der Ansprüche 1 bis 3, **gekennzeichnet durch** eine Blattfeder (11) , die mit wenigstens einer durch einen Schlitz (13) in die Leiterplatte (1) ragenden Schulter (12) gegen das Bauelement (8) drückt.

5. Vorrichtung nach einem der Ansprüche 1 bis 4, **dadurch gekennzeichnet, daß** die Blattfeder (11) an einem Ende in einem Randausschnitt (14) und mit seitlichen Schenkeln auf der Leiterplatte (1) liegt und daß am anderen Ende eine in eine Öffnung (17) der Leiterplatte (1) eingreifende Hakensperre (16) vorgesehen ist.

6. Vorrichtung nach einem der Ansprüche 1 bis 5, **dadurch gekennzeichnet, daß** das Bauelement (8) eine Suppressor-Diode ist, die den definierten Spannungswert festlegt.

7. Vorrichtung nach einem der Ansprüche 1 bis 6, **dadurch gekennzeichnet, daß** der Verbraucher ein Akkumulator ist.

8. Vorrichtung nach Anspruch 7, **dadurch gekennzeichnet, daß** das Schutzelement zusammen mit dem Akkumulator in einem Gehäuse untergebracht ist.

9. Vorrichtung nach Anspruch 7 oder 8, **dadurch gekennzeichnet, daß** der Akkumulator aus wenigstens einer Li-Ion-Zelle besteht.

## Claims

1. A device for protecting an electronic circuit and/or a downstream load from a supply of unduly high electric energy, the device comprising a voltage-limiting component having connectors connected via soldering surfaces (5, 5', 6, 6', 7, 7') to the two current paths of the load and the device being held by a spring (11) under mechanical prestress and being raised and separated from the current paths if unsoldered from the soldering surface, **characterised in that** a pair of strip conductors (2, 2' and 3, 3') are provided for two respective current paths on a circuit board (1) and are interrupted by pairs of soldering surfaces (6, 6' and 7, 7'), one respective soldering surface being connected to the power source and the other connected to the load, and the connectors (9, 10) of the component (8) are welded to the pairs of soldering surfaces (6, 6' and 7, 7').

2. A device according to claim 1, **characterised in that** the strip conductors (2, 2' and 3, 3') have soldering surfaces (4, 4'; 5, 5') for connecting to the current paths and the soldering surfaces (6, 6'; 7, 7') for the component (8) are disposed side by side under the connectors (9, 10) of the component (8).

3. A device according to any of claims 1 to 6, **characterised in that** the component (8) is soldered with a solder having a melting-point defined in dependence on the fixed permissible heating-up temperature.

4. A device according to any of claims 1 to 3, **characterised by** a leaf spring (11) having at least one shoulder (12) which projects through a slot (13) in the circuit board (1) and presses against the component (8).

5. A device according to any of claims 1 to 4, **characterised in that** one end of the leaf spring (11) rests in an edge recess (14), its sides lying on the circuit board (1), and the other end has a hooked catch (16) which engages in an opening (17) in the circuit board (1).

6. A device according to any of claims 1 to 5, **characterised in that** the component (8) is a suppresser diode which fixes the voltage at the defined value.

7. A device according to any of claims 1 to 6, **characterised in that** the load is an accumulator.

8. A device according to claim 7, **characterised in that** the protective element and the accumulator are disposed in a casing.

9. A device according to claim 7 or 8, **characterised in that** the accumulator comprises at least one Li-ion cell.

## Revendications

1. Dispositif de protection d'un circuit électronique et/ou d'un appareil utilisateur monté en aval vis-à-vis de tout apport d'énergie électrique d'une valeur inadmissiblement grande, constitué d'un composant limitant la tension et dont les parties de borne sont reliées par des surfaces (5, 5' ; 6, 6'; 7, 7') de brasure aux deux voies de courant de l'appareil utilisateur et qui est maintenu sous précontrainte mécanique par un ressort (11) et, dans le cas où la brasure lache, est soulevé des surfaces de brasure et est séparé des voies de courant, **caractérisé en ce qu'**il est prévu sur une plaquette (1) à circuit imprimé pour deux voies de courant respectivement une piste (2, 2' et 3, 3') conductrice qui est interrompue par des couples (6, 6' et 7, 7') de surfaces de brasure, parmi lesquelles respectivement l'une est raccordée à la source de courant et l'autre à l'appareil utilisateur et en ce que les parties (9, 10) de bornes du composant (8) sont brasées aux couples (6, 6' et 7, 7') de surfaces de brasure.

2. Dispositif suivant la revendication 1, **caractérisé en ce que** les pistes (2, 2' et 3, 3') conductrices sont munies de surfaces (4, 4' ; 5, 5') de brasure pour les bornes des voies de courant et les surfaces (6, 6' ; 7, 7') de brasure pour le composant (8) sont disposées côte à côte en dessous des parties (9, 10) de bornes du composant (8).

3. Dispositif suivant l'une des revendications 1 ou 2, **caractérisé en ce que** pour braser le composant (8), on choisit une brasure ayant un point de fusion défini en fonction de la température de chauffage admissible qui a été fixée.

4. Dispositif suivant l'une des revendications 1 à 3, **caractérisé par** un ressort (11) à lame qui appuie par au moins un épaulement (12) pénétrant dans une fente (13) ménagée dans la plaquette (1) à circuit imprimé sur le composant (8).

5. Dispositif suivant l'une des revendications 1 à 4, **caractérisé en ce que** le ressort (11) à lame s'applique à une extrémité dans un évidement (14) marginal et par ses branches latérales sur la plaquette (1) à circuit imprimé et en ce qu'il est prévu à l'autre extrémité un crochet (16) de blocage pénétrant dans une ouverture (17) de la plaquette (1) à circuit imprimé.

6. Dispositif suivant l'une des revendication 1 à 5, **caractérisé en ce que** le composant (8) est une diode-suppresseur qui fixe la valeur définie de tension.

7. Dispositif suivant l'une des revendications 1 à 6, **caractérisé en ce que** l'appareil consommateur est un accumulateur.

8. Dispositif suivant la revendication 7, **caractérisé en ce que** l'élément de protection est logé avec l'accumulateur dans un boîtier.

9. Dispositif suivant la revendication 7 ou 8, **caractérisé en ce que** l'accumulateur est constitué d'au moins un élément à ion Li.
